# EUROPÄISCHE PATENTANMELDUNG

(11) **EP 1 119 000 A2**
(43) Veröffentlichungstag der Anmeldung: **25.07.2001**
(21) Anmeldenummer: 01100264.9
(22) Anmeldetag: 03.01.2001
(51) Int. Cl.: G11C 7/00, G11C 29/00

(54) **Schaltungsanordnung mit variabler Anzahl von Datenausgängen und Vorrichtung zum Auslesen von Daten aus einer Schaltungsanordnung mit variabler Anzahl von Datenausgängen**

(30) Priorität: 19.01.2000 DE 10002082
(71) Anmelder: Infineon Technologies AG, 81669 München (DE)
(72) Erfinder: Krause, Gunnar, 81541 München (DE)
(74) Vertreter: Fischer, Volker, Dipl.-Ing.

(57) **Zusammenfassung**

Die Schaltungsanordnung bietet den Vorteil, dass Daten aus einem seriell auslesbaren Datenspeicher über eine frei wählbare Anzahl der vorhandenen Datenausgänge ausgelesen werden können. Dies wird in vorteilhafterweise dadurch erreicht, dass die seriellen Daten über Speicher/Verzögerungsschaltungen zeitlich verzögert an mehrere Datenausgänge geleitet werden.

## Beschreibung

Die Erfindung betrifft eine Schaltungsanordnung gemäß dem Oberbegriff des Patentanspruchs 1 und eine Vorrichtung zum Auslesen von Daten aus einer Schaltungsanordnung gemäß dem Oberbegriff des Patentanspruchs 9.

Eine entsprechende Schaltungsanordnung und eine entsprechende Vorrichtung zum Auslesen von Daten aus einer Schaltungsanordnung sind aus dem Bereich der Speicherbausteine bekannt. In einem Speicherbaustein ist ein Datenspeicher vorgesehen, in dem Daten über den Speicherbaustein abgelegt sind. Die Daten werden beispielsweise zum Überprüfen des Speicherbausteins auf eine korrekte Funktionsfähigkeit von einer Testvorrichtung ausgelesen und bei Testprogrammen verwendet.

Die Aufgabe der Erfindung beruht darin, eine verbesserte Schaltungsanordnung bereit zu stellen, mit der Daten aus einem Datenspeicher über eine einstellbare Anzahl von Datenausgängen auslesbar sind. Eine weitere Aufgabe der Erfindung beruht darin, eine Vorrichtung zum Auslesen von Daten aus einer Schaltungsanordnung mit einer einstellbaren Anzahl von Datenausgängen bereit zu stellen.

Die Aufgabe der Erfindung wird durch die Merkmale des Anspruchs 1 und durch die Merkmale des Anspruchs 9 gelöst.

Ein Vorteil der Schaltungsanordnung nach Anspruch 1 beruht darin, dass die auszulesenden Daten an mehreren Datenausgängen zeitlich versetzt anliegen. Auf diese Weise ist es möglich, sowohl über einen einzigen Datenausgang alle Daten seriell auszulesen oder über mehrere Datenausgänge die Daten gleichzeitig parallel auszulesen.

Die Vorrichtung zum Auslesen von Daten nach dem unabhängigen Anspruch 9 hat den Vorteil, dass Daten über eine variable Anzahl von Dateneingängen seriell und/oder parallel eingelesen werden können. Aus diese Weise ist eine hohe Flexibilität beim Auslesen von Daten gegeben.

Weitere vorteilhafte Ausbildungen der Erfindung sind in den abhängigen Ansprüchen beschrieben. Besonders vorteilhaft ist es, eine Speicher-/Verzögerungsschaltung zwischen dem Datenspeicher und einer Datenpfadschaltung anzuordnen. Diese Anordnung bietet den Vorteil, dass nur die aus dem festgelegten Datenspeicher ausgegeben Daten zeitverzögert an die Datenpfadschaltung gegeben werden. Andere Daten, die aus anderen Datenspeichern über die Datenpfadschaltung nach außen gegeben werden, werden durch diese Schaltungsanordnung nicht beeinflußt.

Eine bevorzugte Ausführungsform der Speicher/Verzögerungsschaltung wird durch die Verwendung eines Master-Slave-FlipFlops erreicht, das eine kostengünstige und mit hoher Zuverlässigkeit arbeitende Speicher/Verzögerungsschaltung ermöglicht.

Vorzugsweise wird die Speicher-/Verzögerungsschaltung von einer Steuereinheit mit einem Steuersignal beaufschlagt, das die Funktion der Speicher-/Verzögerungsschaltung freigibt. Auf diese Weise wird die Speicher-/Verzögerungsschaltung nur dann aktiv, wenn tatsächlich Daten aus dem Datenspeicher ausgegeben werden, wodurch unnötiger Stromverbrauch vermieden wird.

Eine bevorzugte Ausführungsform der Schaltungsanordnung ist die Integration auf einem Speicherbaustein. Durch die erfindungsgemäße Schaltungsanordnung werden die Vielzahl von Datenausgängen, die zum Auslesen von Daten auf einem Speicherbaustein vorhanden sind, flexibel und effizient zum Auslesen von Daten aus einem seriellen Datenspeicher verwendet. Die erfindungsgemäße Schaltungsanordnung kann somit ohne wesentliche Mehrkosten in einem Speicherbaustein integriert werden.

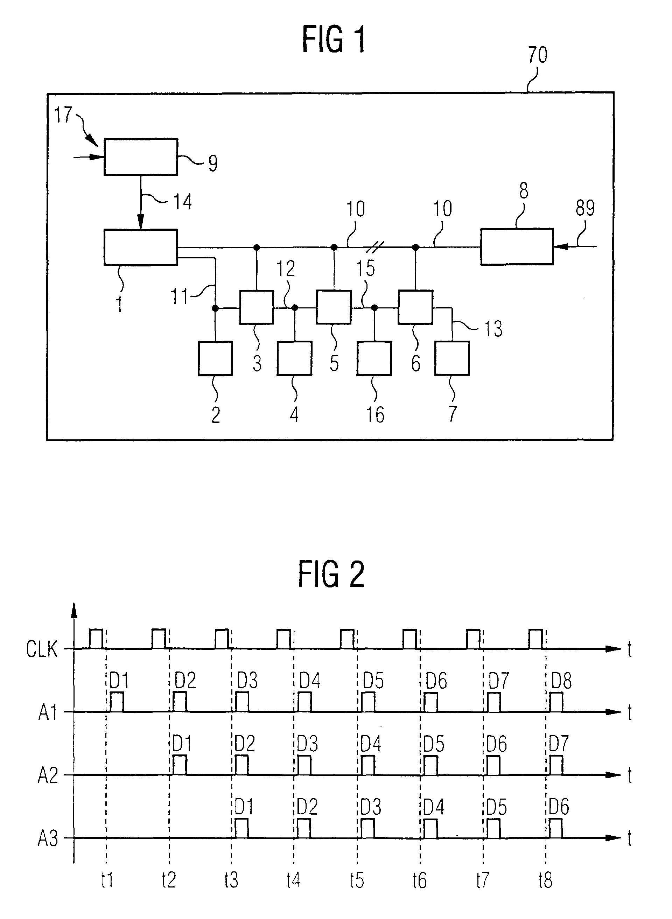

Die Erfindung wird im folgenden anhand der Figuren näher erläutert;
Es zeigen Figur 1 eine erste Schaltungsanordnung mit einem seriell auslesbaren Datenspeicher,
Figur 2 ein Zeitdiagramm über den zeitlichen Verlauf von Datensignalen, die an Datenausgängen anliegen,
Figur 3 eine zweite Schaltungsanordnung mit Datenpfadschaltungen und
Figur 4 eine Vorrichtung zum Auslesen von Daten aus einer Schaltungsanordnung.

Figur 1 zeigt eine Schaltungsanordnung, die auf einem integrierten Halbleiterbaustein, insbesondere auf einem Speicherbaustein (70) angeordnet ist. Weitere übliche Schaltungsteile des Speicherbausteins wie z.B. der Speicher, Stromversorgung, Ein-Ausgänge usw. sind nicht explizit dargestellt. Die erfindungsgemäße Schaltungsanordnung kann in jeder beliebigen Schaltungsanordnung eingesetzt werden und ist auf das beschriebene Ausführungsbeispiel nicht begrenzt.

Die Schaltungsanordnung nach Figur 1 zeigt ein Schieberegister 1, das einen seriellen Datenspeicher darstellt. Anstelle des Schieberegisters 1 kann jede Art eines Speichers verwendet werden, aus dem die abgespeicherten Daten seriell ausgelesen werden. Das Schieberegister 1 ist über eine erste Steuerleitung 14 mit einer Steuerschaltung 9, über eine erste Datenleitung 11 mit einem ersten Datenausgang 2 und mit einer ersten Speicher-/Verzögerungsschaltung 3 verbunden. Die Steuerschaltung 9 weist einen Steuereingang 17 auf, über den die Steuerschaltung 9 in einem Auslesebetrieb schaltbar ist.

Die erste Speicher-/Verzögerungsschaltung 3 ist mit einem Datenausgang über eine zweite Datenleitung 12 an eine zweite Speicher-/Verzögerungsschaltung 5 und an einen zweiten Datenausgang 4 angeschlossen. Die zweite Speicher/Verzögerungsschaltung 5 ist über eine dritte Datenleitung 15 an einen dritten Datenausgang 16 und an eine dritte Speicher/Verzögerungsschaltung 6 angeschlossen. Die dritte Speicher/Verzögerungsschaltung 6 ist über eine vierte Datenleitung 13 an einen vierten Datenausgang 7 angeschlossen.

Der erste, der zweite, der dritte und der vierte Datenausgang 2, 4, 16, 7 sind beispielsweise als Anschlußpin eines Halbleiterspeicherbausteins ausgebildet. Die erste, die zweite und die dritte Speicher-/Verzögerungsschaltung 3, 5, 6 sind vorzugsweise als Master-Slave-FlipFlop ausgebildet. Es kann jedoch auch jede andere Art von Speicher/Verzögerungsschaltung verwendet werden, die ein am Eingang anliegendes Datum um eine vorgebbare Zeit zeitlich verzögert am Ausgang ausgibt.

Die erste, die zweite und die dritte Speicher/Verzögerungsschaltung 3, 5, 6 und das Schieberegister 1 sind über eine Taktleitung 10 mit einer Taktschaltung 8 verbunden. Die Taktschaltung 8 gibt in vorgegebenen Zeitabständen Taktsignale über die Taktleitung 10 aus und stellt damit den an die Taktleitung 10 angeschlossenen Schaltungen eine Zeitbasis zur Verfügung. In einer bevorzugten Ausführungsform kann die Taktschaltung 8 über einen Takteingang 89 angesteuert werden, sodass die Zeitabstände zwischen den Taktsignalen von außen beispielsweise von einem Datenauslesegerät vorgebbar sind.

Die Funktionsweise der Schaltungsanordnung der Figur 1 wird anhand des Zeitdiagramms von Figur 2 erläutert. Figur 2 zeigt in der obersten Zeitachse die zeitliche Abfolge der Taktsignale CLK, die in konstanten Zeitabständen von der Taktschaltung 8 ausgegeben werden. In der zweiten, dritten und vierten Zeitachse, die mit A1, A2 und A3 bezeichnet sind, ist der zeitliche Verlauf des am ersten, zweiten und dritten Datenausgang 2, 4, 16 anliegende Signals angegeben.

Die Steuerschaltung 9 erhält beispielsweise von einer Testschaltung über den Steuereingang 17 das Signal, daß aus dem Schieberegister 1 Daten ausgelesen werden sollen. Daraufhin gibt die Steuerschaltung 9 ein entsprechendes Signal über die erste Steuerleitung 14 an das Schieberegister 1.

Zum Zeitpunkt t1 empfängt das Schieberegister 1 das Taktsignal CLK und gibt daraufhin das erste Datum D1 über die erste Datenleitung 11 aus. Damit liegt das erste Datum D1 kurz nach dem Zeitpunkt t1 am ersten Datenausgang 2 an, der in der Figur 2 mit A1 bezeichnet ist. Zugleich empfängt die erste Speicher-/Verzögerungsschaltung 3 das erste Datum D1 und speichert das erste Datum D1 in einem Zwischenspeicher ab. Zum Zeitpunkt t1 liegt an dem zweiten, dritten und vierten Datenausgang 4, 16, 7 kein Signal an, da die erste Speicher/Verzögerungsschaltung 3 das vom Schieberegister 1 ausgegebene Datum D1 zwischenspeichert und nicht sofort weitergibt.

Zum Zeitpunkt t2 empfängt das Schieberegister 1 und die erste Speicher-/Verzögerungsschaltung 3 ein zweites Taktsignal CLK. Daraufhin gibt das erste Schieberegister 1 das zweite Datum D2 an den ersten Datenausgang 2 und an den Eingang der ersten Speicher-/Verzögerungsschaltung 3. Die erste Speicher/Verzögerungsschaltung 3 gibt nach Erhalt des zweiten Taktsignals CLK das im Zwischenspeicher abgelegte erste Datum D1 über den Ausgang an den zweiten Datenausgang 4 und an den Eingang der zweiten Speicher-/Verzögerungsschaltung 5 weiter. Anschließend speichert die erste Speicher/Verzögerungsschaltung 3 das zweite Datum im Zwischenspeicher ab. Die zweite Speicher-/Verzögerungsschaltung 5 speichert das erste Datum in einem Zwischenspeicher ab.

Somit liegt zum Zeitpunkt t2 das erste Datum D1 am zweiten Datenausgang 4, der in Figur 2 mit A2 bezeichnet ist. Zugleich liegt zum Zeitpunkt t2 das zweite Datum D2 am ersten Datenausgang 2 an.

Nach Erhalt des dritten Taktsignales CLK zum Zeitpunkt t3 gibt das Schieberegister 1 das dritte Datum D3 an den ersten Datenausgang 2 und an den Eingang der ersten Speicher/Verzögerungsschaltung 3. Die erste Speicher/Verzögerungsschaltung 3 gibt nach Erhalt des dritten Taktsignals das zweite Datum D2 an den zweiten Datenausgang 4 und an die zweite Speicher-/Verzögerungsschaltung 5 weiter.

Die zweite Speicher-/Verzögerungsschaltung 5 gibt nach Erhalt des dritten Taktsignales CLK das erste Datum D1 an den dritten Datenausgang 16 und an die dritte Speicher/Verzögerungsschaltung 6 weiter. Anschließend speichert die zweite Speicher-/Verzögerungsschaltung 5 das zweite Datum D2 im Zwischenspeicher ab. Die dritte Speicher/Verzögerungsschaltung 6 speichert das erste Datum D1 in einem Zwischenspeicher ab.

Somit liegen zum Zeitpunkt t3 am ersten Datenausgang 2 das dritte Datum D3, am zweiten Datenausgang 4 das zweite Datum D2 und am dritten Datenausgang 16 das erste Datum D1 an.

In analoger Weise arbeiten das Schieberegister 1, die erste, die zweite und die dritte Speicher-/Verzögerungsschaltung 3, 5, 6 bei dem Empfang weiterer Taktsignale CLK. Die zeitliche Verteilung der Daten über die Datenausgänge 2, 4 und 16 sind in Figur 2 dargestellt. Beispielsweise liegt zum Zeitpunkt t6 das sechste Datum D6 am ersten Datenausgang 2, das fünfte Datum D5 am zweiten Datenausgang 4 und das vierte Datum D4 am dritten Datenausgang 16 an.

Die Schaltungsanordnung nach Figur 1 funktioniert in der Weise, daß alle Daten in serieller zeitlicher Abfolge über die einzelnen Datenausgänge 2, 4, 16 und 7 ausgegeben werden. Zudem sind die über die Datenausgänge 2, 4, 16, 7 seriell ausgegeben Datenströme jeweils gegeneinander um einen Zeittakt versetzt, wobei ein Zeittakt durch den zeitlichen Abstand zweier aufeinander folgender Taktsignale CLK festgelegt ist. In einer Weiterbildung der Erfindung werden die gleichen Daten an den Datenausgängen um eine vorgebbare Anzahl von Zeittakten gegeneinander versetzt ausgegeben. Dazu werden die Daten entsprechend lange in den Speicher-Verzögerungsschaltungen 3,5,6 zwischengespeichert.

Somit ermöglicht die Schaltungsanordnung nach Figur 1 ein Auslesen der Daten aus dem Schieberegister 1 in der Weise, dass alle Daten seriell über nur einen einzigen Datenausgang ausgelesen werden. Dazu kann jeder der vorhandenen Datenausgänge 2, 4, 16, 7 verwendet werden, da an allen diesen Datenausgängen die Daten seriell ausgegeben werden.

Es ist jedoch auch möglich, die Daten über eine frei festlegbare Anzahl von Datenausgängen auszulesen. Verfügt beispielsweise ein Datenauslesegerät über drei Dateneingänge, so können die drei Dateneingänge an den ersten, den zweiten und den dritten Datenausgang 2, 4, 16 angeschlossen werden und die Daten jeweils zu den Zeitpunkten t3, t6, t9 usw. ausgelesen werden. Die Zeitabstände zwischen den zwei Zeitpunkten, zu denen die Daten ausgelesen werden, betragen drei Zeittakte, da die Daten nicht doppelt ausgelesen werden sollen, sondern immer dann auf die drei Datenausgänge 2, 4, 16 zugegriffen wird, wenn an den drei Datenausgängen wieder neue Daten anliegen.

Verfügt das Datenauslesegerät über zwei Dateneingänge, so können die Daten beispielsweise über den ersten und den zweiten Datenausgang 2, 4 ausgelesen werden. Dazu werden die Daten jeweils zu den Zeitpunkten t2, t4, t6 usw. ausgelesen. Der Abstand zwischen den Zeitpunkten, zu denen die Daten ausgelesen werden, beträgt zwei Zeittakte. Jeweils nach zwei Zeittakten liegen an dem ersten und dem zweiten Datenausgang 2, 4 zwei neue Daten an.

Somit ermöglicht die Schaltungsanordnung nach Figur 1 ein Auslesen der Daten aus dem Schieberegister 1 über eine beliebig frei konfigurierbare Anzahl von Datenausgängen 2, 4, 16, 7. Das Datenauslesegerät muß dazu nur den entsprechenden Zeittakt wählen, um ein doppeltes Auslesen oder einen Verlust von Daten zu vermeiden.

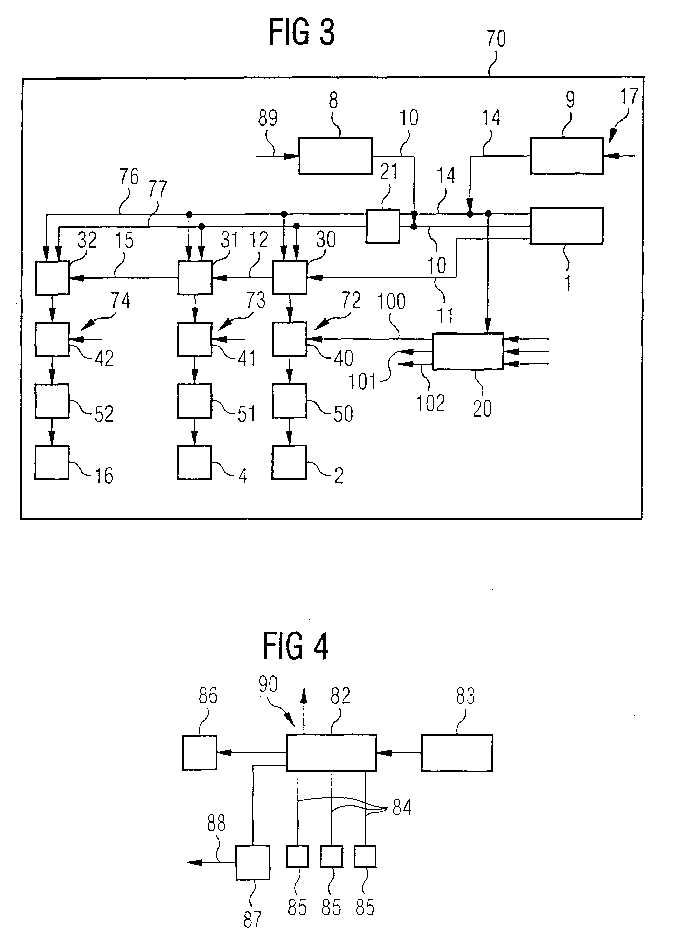

Figur 3 zeigt eine Schaltungsanordnung, die im wesentlichen der Schaltungsanordnung der Figur 1 entspricht. Soweit die Schaltungsanordnung gleiche Teile wie in Figur 1 aufweist, sind diese mit den gleichen Bezugszeichen wie in Figur 1 bezeichnet. Die Schaltungsanordnung der Figur 3 weist als Grundstruktur eine Taktschaltung 8, eine Steuerschaltung 9 und ein Schieberegister 1 auf, die über eine Taktleitung 10 und eine erste Steuerleitung 14 miteinander verbunden sind.

Zusätzlich ist eine Maskierungsschaltung 21 angeordnet, die über die Taktleitung 10 mit der Taktschaltung 8 und über die erste Steuerleitung 14 mit der Steuerschaltung 9 verbunden ist. Die Maskierungsschaltung 21 weist als Ausgänge eine vierte und eine fünfte Steuerleitung 76, 77 auf, die jeweils an eine vierte, fünfte und eine sechste Speicher/Verzögerungsschaltung 30, 31, 32 geführt sind.

Das Schieberegister 1 ist über eine erste Datenleitung 11 mit der vierten Speicher-/Verzögerungsschaltung 30 verbunden. Die vierte Speicher-/Verzögerungsschaltung 30 weist an einem Ausgang eine zweite Datenleitung 12 auf, die zu der fünften Speicher-/Verzögerungsschaltung 31 geführt ist. Die fünfte Speicher-/Verzögerungsschaltung 31 weist an einem Ausgang eine vierte Datenleitung 15 auf, die zur sechsten Speicher/Verzögerungsschaltung 32 geführt ist. Die vierte, fünfte und sechste Speicher-/Verzögerungsschaltung 30, 31, 32 sind über jeweils eine Datenleitung an eine erste, zweite bzw. dritte Datenpfadschaltung 40, 41, 42 angeschlossen.

Die erste, die zweite und die dritte Datenpfadschaltung 40,41,42 weisen jeweils einen ersten, zweiten bzw. dritten Steuereingang 72, 73, 74 auf, an die ein erster, zweiter bzw. dritter Steuerausgang 100, 101, 102 einer dritten Steuerschaltung 20 geführt ist. Die dritte Steuerschaltung 20 steuert die erste, zweite und dritte Datenpfadschaltung 40, 41, 42.

Die erste, die zweite und die dritte Datenpfadschaltung 40, 41, 42 sind über eine erste, zweite bzw. dritte Verstärkerschaltung 50, 51, 52 an einen ersten, zweiten bzw. dritten Datenausgang 2,4,16 angeschlossen. Datenpfadschaltungen sind Leitungsschaltungen, mit denen Daten aus inneren Bereichen eines Speicherbausteins zu Datenausgängen geführt werden, die in Randbereichen eines Speicherbausteins angeordnet sind.

Die Schaltungsanordnung nach Figur 3 funktioniert folgendermaßen:
Sollen aus dem Schieberegister 1, das einen seriellen Datenspeicher darstellt, Daten ausgelesen werden, so wird an die Steuerschaltung 9 über den Steuereingang 17 ein Auslesesignal zugeführt. Daraufhin gibt die Steuerschaltung 9 ein entsprechenden Auslesesignal über die erste Steuerleitung 14 an das Schieberegister 1, die Maskierungsschaltung 21 und die dritte Steuerschaltung 20. Zugleich werden von der Taktschaltung 8 in festgelegten Zeitabständen Taktsignale über die Taktleitung 10 an das Schieberegister 1 und an die Maskierungsschaltung 21 gegeben.

In einer bevorzugten Ausführungsform kann die Taktschaltung 8 über einen Takteingang 89 angesteuert werden, sodass die Zeitabstände zwischen den Taktsignalen von außen beispielsweise von einem Datenauslesegerät vorgebbar sind.

Das Schieberegister 1 gibt nach Empfang eines Taktsignales CLK entsprechend der in Figur 2 dargestellten Weise ein erstes Datum D1 über die erste Datenleitung 11 aus. Zum Zeitpunkt t1 wird das erste Datum D1 an den Eingang der vierten Speicher-/Verzögerungsschaltung 30 gegeben.

Die Maskierungsschaltung 21 gibt über die vierte Steuerleitung 76 das von der Steuerschaltung 9 ausgegebene Auslesesignal an die vierte, fünfte und sechste Speicher/Verzögerungsschaltung 30, 31, 32 weiter. Die Maskierungsschaltung 21 gibt die Taktsignale der Taktschaltung 8 über die fünfte Steuerleitung 77 nur dann weiter, wenn gleichzeitig ein Auslesesignal von der Steuerschaltung 9 ausgegeben wird. Wird von der Steuerschaltung 9 ein Auslesesignal ausgegeben und kommt gleichzeitig von der Taktschaltung 8 ein Taktsignal an die Maskierungsschaltung 21, so wird dieses Taktsignal über die fünfte Steuerleitung 77 an die vierte, fünfte und sechste Speicher-/Verzögerungsschaltung 30, 31, 32 weitergegeben.

Die vierte, fünfte und sechste Speicher/Verzögerungsschaltungen 30, 31, 32 sind vorzugsweise als Master-Slave-FlipFlop ausgebildet und funktionieren in folgender Weise:
Die vierte, fünfte und sechste Speicher/Verzögerungsschaltung 30, 31, 32 geben das über die erste, zweite bzw. dritte Datenleitung 11, 12, 13 zugeführte Datum an die erste, zweite bzw. dritte Datenpfadschaltung 40, 41, 42, wenn über die vierte Steuerleitung 76 ein Auslesesignal zugeführt wird. Gleichzeitig wird das zugeführte Datum gespeichert. Nach Erhalt eines weiteren Taktsignales CLK wird das gespeicherte Datum über die zweite Datenleitung 12 bzw. die dritte Datenleitung 15 weitergegeben.

Die Funktionsweise der vierten, fünften und sechsten Speicher-/Verzögerungsschaltung 30, 31, 32 wird am Zeitdiagramm der Figur 2 erklärt. Zum Zeitpunkt t1 liegt ein von der Steuerschaltung 9 ausgegebenes Auslesesignal an der vierten, fünften und sechsten Speicher-/Verzögerungsschaltung 30, 31, 32 an. Gleichzeitig wird ein von der Taktschaltung 8 ausgegebenes Taktsignal an die vierte, fünfte und sechste Speicher/Verzögerungsschaltung 30, 31, 32 geführt. Zudem gibt das Schieberegister 1 ein erstes Datum D1 über die erste Datenleitung 11 aus.

Die vierte Speicher-/Verzögerungsschaltung 30 gibt das erste Datum D1 nach dem Erhalt an die erste Datenpfadschaltung 40 weiter und speichert das erste Datum D1 zugleich in einem Zwischenspeicher ab. An den Dateneingängen der fünften und sechsten Verzögerungschaltung 31, 32 liegt kein Datum an, sodass der zweiten und der dritten Datenpfadschaltung 41, 42 kein Datum zugeführt wird.

Zum Zeitpunkt t2 gibt die Taktschaltung 8 ein weiteres Taktsignal CLK ab, das an die vierte, fünfte und sechste Speicher-/Verzögerungsschaltung 30, 31, 32 weitergegeben wird. Nach Erhalt des Taktsignales gibt das Schieberegister 1 ein zweites Datum D2 über die erste Datenleitung 11 an die vierte Speicher-/Verzögerungsschaltung 30. Die vierte Speicher/Verzögerungsschaltung 30 gibt nach Erhalt des zweiten Taktsignales das zwischengespeicherte erste Datum D1 über die zweite Datenleitung 12 an die fünfte Speicher/Verzögerungsschaltung 31 weiter.

Nach Erhalt des zweiten Datums D2 gibt die vierte Speicher/Verzögerungsschaltung 30 das zweite Datum D2 an die erste Datenpfadschaltung 40 und speichert gleichzeitig das zweite Datum D2 in einem Zwischenspeicher ab.

Die fünfte Speicher-/Verzögerungsschaltung 31 gibt zum Zeitpunkt t2 das erste Datum D1 an die zweite Datenpfadschaltung 41 und speichert gleichzeitig das erste Datum D1 in einem Zwischenspeicher ab.

Somit liegen zum Zeitpunkt t2 an der ersten Datenpfadschaltung 40 das zweite Datum D2 und an der zweiten Datenpfadschaltung 41 das erste Datum D1 an.

Nach Erhalt des nächsten Taktsignales CLK gibt das Schieberegister 1 das dritte Datum D3 an die vierte Speicher/Verzögerungsschaltung 30 ab. Die vierte Speicher/Verzögerungsschaltung 30 gibt nach Erhalt des Taktsignales das zwischengespeicherte zweite Datum D2 an die fünfte Speicher-/Verzögerungsschaltung 31 weiter. Die vierte Speicher/Verzögerungsschaltung 30 gibt nach Erhalt des dritten Datums D3 das dritte Datum D3 an die erste Datenpfadschaltung 40 weiter und speichert gleichzeitig das dritte Datum D3 in dem Zwischenspeicher ab.

Nach Erhalt des dritten Taktsignales gibt die fünfte Speicher-/Verzögerungsschaltung 31 das zwischengespeicherte erste Datum D1 über die vierte Datenleitung 15 an die sechste Verzögerungschaltung 32 weiter. Nach Erhalt des zweiten Datums D2 gibt die fünfte Speicher-/Verzögerungsschaltung 31 das zweite Datum D2 an die zweite Datenpfadschaltung 41 weiter und speichert gleichzeitig das zweite Datum D2 in dem Zwischenspeicher ab.

Die sechste Speicher-/Verzögerungsschaltung 32 gibt nach Erhalt des ersten Datums D1 das erste Datum D1 an die dritte Datenpfadschaltung 42 weiter und speichert gleichzeitig das erste Datum D1 in einem Zwischenspeicher ab.

Folglich liegen zum Zeitpunkt t3 an der ersten Datenpfadschaltung 40 das dritte Datum D3, an der zweiten Datenpfadschaltung 41 das zweite Datum D2 und an der dritten Datenpfadschaltung 42 das erste Datum D1 an.

Die dritte Steuerschaltung 20 erhält wie das Schieberegister 1 das Auslesesignal der Steuerschaltung 9 und gibt daraufhin über die erste, zweite und dritte Steuerleitung 100, 101, 102 an die erste, zweite und dritte Datenpfadschaltung 40, 41, 42 das Signal, ein zugeführtes Datum über die erste, zweite bzw. die dritte Verstärkerschaltung 50, 51, 52 an den ersten, zweiten und dritten Datenausgang 2, 4, 16 weiterzugeben. Somit liegen nur mit geringem Zeitverzug die der ersten, zweiten und dritte Datenpfadschaltung 40, 41, 42 zugeführten Daten auch an dem ersten, zweiten bzw. dritten Datenausgang 2, 4, 16 an.

Die Schaltungsanordnung nach Figur 3 ist somit in der Weise aufgebaut, dass am ersten Datenausgang 2 die Daten entsprechend dem Signalablauf der zweiten Zeitachse A1 der Figur 2 anliegen. Die Daten des zweiten Datenausganges 4 liegen in der zeitlichen Reihenfolge an, wie in der dritten Zeitachse A2 in Figur 2 dargestellt ist. Am dritten Datenausgang 16 liegen die Daten entsprechend der vierten Zeitachse A3 der Figur 2 an.

Der wesentliche Vorteil der Schaltungsanordnung der Figur 3 gegenüber der Schaltungsanordnung der Figur 1 beruht darin, dass die Daten ausgehend vom Schieberegister 1 nicht direkt auf die Datenausgänge 2, 4, 16 ausgegeben werden, sondern über entsprechende Datenpfadschaltungen 40, 41, 42 zu den zugeordneten Datenausgängen 2, 4, 16 geführt werden. Die Verwendung der bereits in einem Halbleiterbaustein vorhandenen Datenpfadschaltungen 40, 41, 42 bietet den Vorteil, dass keine separaten Datenleitungen vom Schieberegister 1 zu den Datenausgängen 2, 4, 16 geführt werden müssen, sondern die zum Auslesen von Daten auf einem Speicherchip vorhandenen Datenpfadschaltungen 40, 41, 42 verwendet werden. Somit wird eine effiziente Ausnutzung der bereits vorhandenen Datenstruktur erreicht.

Figur 4 zeigt eine Schaltungsanordnung für ein Datenauslesegerät wie es beispielsweise in einem Testgenerator zum Testen eines Speicherbausteins angeordnet ist. Das Datenauslesegerät verfügt über eine Auslesesteuerschaltung 82, die mit einem Datenspeicher 83 und einer Eingabevorrichtung 86 verbunden ist. Die Auslesesteuerschaltung 82 ist über Datenleitungen 84 mit Datenein-/ausgängen 85 verbunden. Zudem ist ein Takttreiber 87 vorgesehen, der mit der Auslesesteuerschaltung 82 in Verbindung steht. Der Takttreiber 87 weist eienen Taktausgang 88 auf. Zudem weist die Auslesesteuerschaltung 82 einen Steuerausgang 90 auf.

Zum Auslesen von Daten aus einer Schaltungsanordnung entsprechen den Figuren 1 oder 3 ist das Datenauslesegerät der Figur 4 in folgender Weise angeschlossen:
Der Steuerausgang 90 ist an den Steuereingang 17 der Steuerschaltung 9 und der Taktausgang 88 an den Takteingang 89 der Taktschaltung 8 angeschlossen. Die Bedienperson des Datenauslesegerätes gibt über die Eingabevorrichtung 86 den Typ des zu prüfenden Speicherbausteins ein. Im Datenspeicher 83 ist eine Liste abgelegt, in der abhängig von dem Speicherbausteintyp die Anzahl der zum Auslesen von Daten verwendbaren Datenausgänge 2, 4, 16, 7 und die Taktfrequenz der Taktschaltung 8 des Speicherbausteins abgelegt sind.

Die Auslesesteuerschaltung 82 verwendet die gesamte Anzahl der zu Verfügung stehenden Datenausgänge, wenn diese kleiner ist als die Anzahl der eigenen Datenein-/ ausgänge 85. Falls der zu überprüfende Speicherbaustein entsprechend Figur 1 vier Datenausgänge und das Datenauslesegerät entsprechend Figur 4 nur drei Datenein-/ausgänge aufweist, so verwendet das Datenauslesegerät nur drei Datenein-/ausgänge 85 zum Auslesen der im Schieberegister 1 abgespeicherten Daten. Bei diesem Beispiel werden die drei Datenein-/ ausgänge 85 mit dem ersten, zweiten und dritten Datenausgang 2, 4, 16 verbunden. Zudem werden die am ersten, zweiten und dritten Datenausgang 2, 4, 16 anliegenden Daten nur alle drei Zeittakte ausgelesen. Somit werden die Daten zum Zeitpunkt t3, t6, t9 usw. ausgelesen. Auf diese Weise wird erreicht, dass an jedem der drei Ausgänge 2, 4, 16 unterschiedliche Daten anliegen und zudem kein Datum, dass vom Schieberegister 1 ausgegeben wurde, verloren geht.

Der Zeitabstand, in dem das Datenauslesegerät die Daten ausliest, entspricht somit dreimal dem Zeittakt zwischen zwei Taktsignalen.

Hat der Speicherbaustein beispielsweise nur einen Datenausgang 2, so wird das Datenauslesegerät nur einen Datenein-/ ausgang 85 zum Auslesen der Daten verwenden und diesen an den Datenausgang 2 anschließen. Bei diesem Beispiel werden die Daten bei jedem Taktsignal der Taktschaltung 8 aus dem Datenausgang 2 ausgelesen, so daß alle Daten seriell über einen Datenausgang ausgelesen werden.

In einer weiteren Ausführungsform werden die vom Datenauslesegerät zu verwendenden Datenein-/ ausgänge 85 über die Eingabevorrichtung 86 ausgewählt. In diesem Fall kann eine Bedienperson die Anzahl der abzufragenden Datenausgänge 2, 4, 16, 7 festlegen. Zugleich kann über die Eingabevorrichtung 86 auch der vom Speicherbaustein verwendete Zeittakt der Taktschaltung 8 eingegeben werden. Das Auslesen der Daten erfolgt entsprechend dem beschriebenen Verfahren, wobei die Anzahl der verwendeten Datenausgänge und der Zeittakt, nach dem die Daten abgefragt werden entsprechend angepaßt werden.

Das Datenauslesegerät entsprechend Figur 4 weist im wesentlichen den Vorteil auf, dass die Anzahl der Datenein-/ ausgänge 85, über die Daten eingelesen werden in der Anzahl variabel einstellbar ist. Dadurch können Daten aus Schaltungsanordnungen mit einer beliebigen Anzahl der vorhandenen Datenausgänge ausgelesen werden. Weiterhin ist es von Vorteil, dass die Abtastzeiten, zu denen die Auslesesteuerschaltung 82 Daten über die Datenein-/ ausgänge 85 einliest, in Abhängigkeit von der Anzahl der verwendeten Datenein-/ ausgänge 85 einstellbar ist und vorzugsweise auf den Zeittakt der abzufragenden Schaltungsanordnung eingestellt werden kann.

Speicher-/Verzögerungsschaltungen in Form von Master-Slave-FlipFlops sind beispielsweise aus Tietze, Schenk, Halbleiterschaltungstechnik, 9. Auflage, Springer Verlag, 1991 (ISBN 3-540-19475-4) auf den Seiten 235-240 bekannt.

## Patentansprüche

1. Schaltungsanordnung mit einem seriell auslesbaren Datenspeicher,
- der über eine Ausgangsleitung an einen ersten Datenausgang angeschlossen ist,
- der über eine Taktleitung mit einem Taktgeber verbunden ist,
**dadurch gekennzeichnet**,
daß ein zweiter Datenausgang (4) vorgesehen ist,
daß die Ausgangsleitung (11) an den Eingang einer Speicher/Verzögerungsschaltung (3) angeschlossen ist,
daß der Ausgang der Speicher-/Verzögerungsschaltung (3) an den zweiten Datenausgang (4) angeschlossen ist,
daß der Datenspeicher (1) beim Empfang eines Taktsignals (CLK) ein abgespeichertes Datum (D1,D2,D3) über die Ausgangsleitung (11) ausgibt, und
daß die Speicher-/Verzögerungsschaltung (3) das vom Datenspeicher (1) ausgegebene Datum (D1,D2,D3) an den zweiten Datenausgang (4) zeitlich verzögert weitergibt.

2. Schaltungsanordnung nach Anspruch 1, dadurch gekennzeichnet,
daß die Speicher-/Verzögerungsschaltung (3) an die Taktleitung (10) angeschlossen ist, und dass die Speicher/Verzögerungsleitung (3) das Datum (D1,D2,D3) um ein Taktsignals zeitlich verzögert an den zweiten Datenausgang (4) ausgibt.

3. Schaltungsanordnung nach Anspruch 1, dadurch gekennzeichnet,
daß ein dritter Datenausgang (16) angeordnet ist,
daß der Ausgang der ersten Speicher-/Verzögerungsschaltung (3) an den Eingang einer zweiten Speicher/Verzögerungsschaltung (5) angeschlossen ist,
daß die zweite Speicher-/Verzögerungsschaltung (5) an die Taktleitung (10) angeschlossen ist,
daß der Ausgang der zweiten Speicher-/Verzögerungsschaltung (5) an den dritten Datenausgang (16) angeschlossen ist,
daß die zweite Speicher-/Verzögerungsschaltung (5) das von der ersten Speicher-/Verzögerungsschaltung (3) zugeführte Datum um ein Taktsignal zeitlich verzögert an den dritten Datenausgang (16) weitergibt.

4. Schaltungsanordnung nach einem der Ansprüche 1 bis 3, dadurch gekennzeichnet,
daß die Speicher-Verzögerungsschaltung (30,31,32) an eine Datenpfadschaltung (40,41,42) angeschlossen ist, über die Daten zu einem Datenausgang (2,4,16) geführt werden.

5. Schaltungsanordnung nach Anspruch 1 bis 4, dadurch gekennzeichnet, daß als Speicher-/Verzögerungsschaltung (3,5,6;30,31,32) eine Master-Slave Flip-Flop-Schaltung angeordnet ist.

6. Schaltungsanordnung nach einem der vorhergehenden Ansprüche 1 bis 5, dadurch gekennzeichnet, daß der Datenspeicher (1) über eine Steuerleitung (14) mit einer Steuereinheit (9) verbunden ist, die die Ausgabe von Daten aus dem Datenspeicher (1) mit einem vorgegebenen Steuersignal freigibt.

7. Schaltungsanordnung nach einem der Ansprüche 1 bis 6, dadurch gekennzeichnet, daß die Speicher-/Verzögerungsschaltung (30,31,32) über eine Steuerleitung (76) mit einer Steuereinheit (9) verbunden ist, die die Weitergabe von Daten freigibt.

8. Schaltungsanordnung nach einem der vorhergehenden Ansprüche 1 bis 7, dadurch gekennzeichnet, daß die Schaltungsanordnung auf einem Speicherbaustein (70) integriert ist, und daß in dem Datenspeicher (1) Informationen über den Speicherbaustein (70) abgelegt sind.

9. Vorrichtung zum Auslesen von Daten aus einer Schaltungsanordnung
- mit einer vorgegebenen Anzahl von Dateneingängen, über die Daten einlesbar sind,
- mit einer Steuerschaltung, die mit einem Datenspeicher verbunden ist,
dadurch gekennzeichnet,
daß in dem Datenspeicher (83) eine Anzahl von aktiven Dateneingängen (85) festlegbar ist, und
daß die Steuerschaltung (82) über die vorgegebene Anzahl von Dateneingängen (85) Daten parallel einliest.

10. Vorrichtung nach Anspruch 9, dadurch gekennzeichnet, daß in dem Datenspeicher (83) ein Zeittakt einstellbar ist,
daß die Steuerschaltung (82) die Daten in dem vorgebbaren Zeittakt einliest.

11. Vorrichtung nach Anspruch 9, dadurch gekennzeichnet, daß im Datenspeicher (83) eine Taktzeit ablegbar ist, und
daß sich der Zeittakt aus der Anzahl der Dateneingänge multipliziert mit der Taktzeit berechnet.
